# EUROPÄISCHE PATENTSCHRIFT

(11) **EP 1 567 696 B1**
(45) Veröffentlichungstag und Bekanntmachung des Hinweises auf die Patenterteilung: **21.10.2009**
(21) Anmeldenummer: 04763570.1
(22) Anmeldetag: 28.07.2004
(51) Int. Cl.: C30B 23/00, C30B 29/40

(54) **VERFAHREN UND VORRICHTUNG ZUR EIN-EINKRISTALL-HERSTELLUNG MIT GASDURCHLÄSSIGER TIEGELWAND**
METHOD AND DEVICE FOR ALN SINGLE CRYSTAL PRODUCTION WITH GAS-PERMEABLE CRUCIBLE WALLS
PROCEDE ET DISPOSITIF DE PRODUCTION DE MONOCRISTAL DE NITRURE D'ALUMINIUM (ALN), A PAROI CUPULIFORME PERMEABLE AUX GAZ

(30) Priorität: 31.07.2003 DE 10335538
(43) Veröffentlichungstag der Anmeldung: 31.08.2005
(73) Patentinhaber: SiCrystal Aktiengesellschaft, 91052 Erlangen (DE)
(72) Erfinder: RASP, Michael, 91058 Erlangen (DE); SCHMITT, Erwin, 91091 Grossenseebach (DE); STRAUBINGER, Thomas, 91052 Erlangen (DE); VOGEL, Michael, 90489 Nürnberg (DE)
(74) Vertreter: Bauerschmidt, Peter
(86) Internationale Anmeldenummer: PCT/EP2004/008457
(87) Internationale Veröffentlichungsnummer: WO 2005/012602

(56) Entgegenhaltungen:
- EP-A- 1 270 768
- US-A- 6 045 612
- US-A- 6 048 813
- US-A- 6 066 205
- PATENT ABSTRACTS OF JAPAN Bd. 1999, Nr. 02, 26. Februar 1999 (1999-02-26) & JP 10 291899 A (SHOWA DENKO KK), 4. November 1998 (1998-11-04)
- CARLOS ROJO J ET AL: "Report on the growth of bulk aluminum nitride and subsequent substrate preparation" JOURNAL OF CRYSTAL GROWTH, NORTH-HOLLAND PUBLISHING, AMSTERDAM, NL, Bd. 231, Nr. 3, Oktober 2001 (2001-10), Seiten 317-321, XP004274132 ISSN: 0022-0248 in der Anmeldung erwähnt
- SLACK G A ET AL: "Growth of high purity AIN crystals" JOURNAL OF CRYSTAL GROWTH, NORTH-HOLLAND PUBLISHING CO. AMSTERDAM, NL, Bd. 34, 1976, Seiten 263-279, XP002971531 ISSN: 0022-0248 in der Anmeldung erwähnt

## Beschreibung

Die Erfindung betrifft ein Verfahren zur Herstellung eines Aluminiumnitrid (A1N)-Einkristalls, insbesondere eines Volumeneinkristalls, bei dem mindestens eine Gasphase zumindest teilweise aus einem Quellmaterial, das sich in einem Vorratsbereich eines Tiegels befindet und zumindest eine Komponente des AlN-Einkristalls enthält, erzeugt wird und der AlN-Einkristall in einem Kristallbereich des Tiegels mittels Wachstum aus der Gasphase erzeugt wird. Außerdem betrifft die Erfindung auch eine Vorrichtung zur Herstellung eines AlN-Einkristalls, insbesondere eines Volumeneinkristalls, gemäß dem Oberbegriff des Patentenanspruchs 8. Eine solche Vorrichtung ist aus der JP 10-291899 A bekannt.

Einkristallines Aluminiumnitrid (AlN) ist ein III-V-Verbundhalbleiter mit außergewöhnlichen Eigenschaften. Insbesondere der sehr hohe Bandabstand von 6,2 eV lassen dieses Halbleitermaterial als sehr vielversprechend für einen breiten Anwendungsbereich in der Elektronik und Optoelektronik erscheinen. Allerdings ist es bis heute nicht gelungen, AlN-Einkristalle in einer von der Halbleiter-Industrie geforderten Größe und auch Qualität herzustellen. Dadurch wird derzeit die Verbreitung von Aluminiumnitrid als Basis-Halbleitermaterial für elektronische oder optoelektronische Bauelemente noch begrenzt.

Zur Herstellung eines AlN-Einkristalls sind verschiedene Verfahren sowie zugehörige Vorrichtungen bekannt. Am häufigsten sind bislang Züchtungsverfahren beschrieben worden, bei denen der AlN-Einkristall aus einer Gasphase mit Aluminium- und Stickstoff-haltigen Gasspezies auskristallisiert, also aufwächst. Hierbei kommen physikalische, chemische und gemischtphysikalisch-chemische Abscheideverfahren (PVT (= Physical Vapor Transport), CVD (= Chemical Vapor Deposition), ...) zum Einsatz. Die Gasphase kann zum einen mittels Sublimation von festem (beispielsweise polykristallinem) AlN erzeugt werden. Dies ist insbesondere in der EP 1 270 768 A1 beschrieben. Zum, anderen ist jedoch auch ein Verdampfen von flüssigem Aluminium und eine Zugabe von gasförmigem Stickstoff, wie es in einem Ausführungsbeispiel in der US 6,045,612 beschrieben ist, möglich. Schließlich lässt sich die Gasphase auch mittels einer Sputter-Technik aus einem festen oder flüssigen Target erzeugen. Ausführungsbeispiele hierzu sind mit der *WO 02*/*44443 A1* offenbart. Im Unterschied zu den vorstehend genannten Verfahren wächst der AlN-Einkristall bei dem mit der US 6,066,205 offenbarten Verfahren nicht aus einer Gasphase, sondern aus einer Schmelze aus flüssigem Aluminium, das mit gasförmigem Stickstoff versetzt ist, auf. In die Schmelze wird ein Keimkristall eingetaucht.

Grundlegende Untersuchungen zur Herstellung von einkristallinem AlN wurden bereits in den 1970er Jahren von G.A. Slack und T.F. McNelly durchgeführt und die Ergebnisse in dem Fachaufsatz "AlN Single Crystals", J. Cryst. Growth 42 (1977), S. 560-563*,* sowie in dem Übersichtsaufsatz "Growth of High Purity AlN Crystals.", J. Cryst. Growth 34 (1976), S. 263-279 publiziert. Insbesondere beschreiben diese beiden Autoren ein Sublimationsverfahren (= PVT-Verfahren) mit einem geschlossenen, d.h. versiegelten Züchtungstiegel, bei dem kein gesonderter Keimkristall zum Einsatz kommt. Als besonders vorteilhafte Materialien für den Züchtungstiegel werden Wolfram, Rhenium und eine Wolfram-Rhenium-Legierung angegeben. Ähnliche Sublimationsverfahren, bei denen ebenfalls ein geschlossener Tiegel verwendet wird, werden in den Fachaufsätzen von J.C. Rojo et al: "Report on the Growth of Bulk Aluminium Nitride and Subsequent Substrate Preparation", J. Crys. Growth 231 (1001), S. 317-321*,* G.A. Slack: "Growth of AlN Single Crystals" MRS Symp. Proc. 512 (1998), S. 35-40 sowie von L.J Schowalter et al.: "Preparation and Characterization of Single-Crystal Aluminium Nitride Substrates" MRS 1999 Fall Meeting, Paper W6.7 (2000*)* beschrieben. Deren Autoren nehmen dabei jeweils auf die grundlegenden Arbeiten von Slack und McNelly Bezug. Bei den Verfahren, die mit einem geschlossenen Tiegel arbeiten, besteht - abgesehen von einer Temperaturvariation mittels der außerhalb des Tiegels angeordneten Heizeinrichtung - allerdings nach dem Versiegeln des Tiegels praktisch keine Möglichkeit mehr, steuernd in die Prozessatmosphäre in der Innenzone des Tiegels einzugreifen. Dementsprechend ist die Einflussnahme auf das AlN-Einkristallwachstum beschränkt.

Auch in der EP 1 270 768 A1 wird ein Sublimationsverfahren in einem geschlossenen Züchtungstiegel beschrieben. Im Rahmen eines Ausführungsbeispiels ist auch ein nicht versiegelter Tiegel offenbart, bei dem Öffnungen in der Tiegelwand vorgesehen sind, so dass grundsätzlich ein Austausch zwischen Innen- und Außenzone des Tiegels möglich ist. Anhand eines auf den Züchtungsvorgang in der Innenzone des Tiegels abgestimmten und gezielt eingestellten Stickstoff-Drucks in der Außenzone wird verhindert, dass Komponenten der Aluminium- und Stickstoff-haltigen Gasphase über die Öffnungen von der Innenzone in die Außenzone gelangen und auch dass Stickstoff von außen in die Innenzone eindringt.

Andere Sublimationsverfahren arbeiten unter Zuhilfenahme offener Züchtungstiegel, so dass mittels in der Tiegelwand vorgesehenen Öffnungen ein Gasaustausch zwischen der Innenzone und der Außenzone des Tiegels stattfinden kann. Ein solches Verfahren wird beispielsweise mit der US 6,045,612 offenbart. Die Öffnungen sind Bestandteil eines gesonderten Gasabführsystems, das dazu bestimmt ist, atomare oder molekulare Verunreinigungen oder nicht-stöchiometrische Anteile in der Gasphase von der Wachstumsoberfläche des aufwachsenden AlN-Einkristalls wegzuleiten. Weitere Verfahren und Vorrichtungen mit einem offenen Tiegel sind in den Fachaufsätzen von C.M. Balkas et al.: "Sublimation Growth and Characterization of Bulk Aluminium Nitride Single Crystals", J. Cryst. Growth 179 (1997), S. 363-370*,* R. Schlesser et al.: "Growth of Bulk AlN Crystals by Vaporization of Aluminium in a Nitrogen Atmosphere", J. Cryst. Growth 234 (2002), S. 349-353 und von R. Schlesser et al.: "Seeded Growth of AlN Bulk Single Crystals by Sublimation", J. Cryst. Growth 241 (2002), S. 416-420 beschrieben. Bei den Verfahren, die mit einem offenen Tiegel arbeiten, kann es aufgrund des gezielt eingestellten und insbesondere kontinuierlichen Gasflusses dazu kommen, dass sich im Bereich der Wachstumsoberfläche unerwünschte und das Kristallwachstum beeinträchtigende laminare oder turbulente Strömungen in der Gasphase bilden. Außerdem kann der Gasfluss aufgrund des ständigen Zu- und Abtransports von Gasphasenkomponenten auch die Stöchiometrie an der Wachstumsoberfläche stören. Gleiches gilt für das Temperaturfeld im Tiegel, das durch vom Gasfluss hervorgerufene Konvektion negativ beeinflusst werden kann.

Bekannt sind Methoden zur Züchtung eines AlN-Einkristalls mit und ohne Zuhilfenahme eines Keimkristalls. Ein derartiger Keimkristall dient zur anfänglichen Unterstützung des Kristallwachstums. Wie aus den Fachaufsätzen von Y. Shi et al.: "Influence of Buffer Layer and 6H-SiC Substrate Polarity on the Nucleation of AlN Grown by the Sublimation Sandwich Technique", J. Cryst. Growth 233 (2001), S. 177-186*,* L. Liu: "Growth Mode and Defects in Aluminium Nitride Sublimed on (0001) 6H-SiC Substrates", MRS Internet J. Nitride Semicond. Res. 6, 7 (2001*) und von* Y. Shi et al.: "New Technique for Sublimation Growth of AlN Single Crystals", MRS Internet Nitride Semicond. Res. 6, 5 (2001*),* hervorgeht, können dabei sowohl beschichtete als auch unbeschichtete Keimkristalle, insbesondere aus dem Halbleitermaterial Siliciumcarbid (SiC), verwendet werden. Die Beschichtung kann dabei mindestens eine A1N-, eine SiC- oder eine gemischte AlNₓSiC₁₋ₓ-Epitaxieschicht beinhalten.

Trotz der vielfältigen Arbeiten zur Herstellung von einkristallinem AlN ist es bislang nicht gelungen, derartige Einkristalle in ausreichender Größe und Qualität herzustellen. Dies liegt insbesondere auch an den sehr hohen Anforderungen an die Prozessbedingungen während der Züchtung. Die AlN-Züchtung ist ein schwer zu kontrollierender PVT-Prozess.

Der Erfindung liegt die Aufgabe zu Grunde, ein Verfahren und eine Vorrichtung anzugeben, mittels der ein AlN-Einkristall in einer Größe und Qualität entsprechend den Anforderungen für eine großtechnische und wirtschaftliche AlN-Bauelementefertigung hergestellt werden kann.

Zur Lösung der das Verfahren betreffenden Aufgabe wird ein Verfahren entsprechend den Merkmalen des unabhängigen Patentanspruchs 1 angegeben.

Bei dem erfindungsgemäßen Verfahren handelt es sich um ein Verfahren zur Herstellung eines AlN-Einkristalls der eingangs bezeichneten Art, das gekennzeichnet ist dadurch, dass zumindest eine gasförmige Komponente zumindest zeitweise mittels einer ersten Diffusion zwischen einer Außenzone des Tiegels und einer Innenzone des Tiegels transferiert wird.

Zur Lösung der die Vorrichtung betreffenden Aufgabe wird eine Vorrichtung entsprechend den Merkmalen des unabhängigen Patentanspruchs 8 angegeben.

Die Erfindung beruht dabei auf der Erkenntnis, dass mittels einer Diffusion beispielsweise von Komponenten der an der Züchtung beteiligten Gasphase durch die Tiegelwand des verwendeten Tiegels eine deutlich verbesserte Kontrolle und auch Steuerung der Prozessverhältnisse innerhalb des Tiegels erreicht werden kann. Als Komponenten der Gasphase kommen dabei neben den Aluminium- und Stickstoff-haltigen Gasspezies insbesondere auch Dotierstoffgase, Inert- und Trägergase in Betracht. Der durch die Diffusion bedingte Gasaustausch ist insbesondere in beide Richtungen möglich, d.h. von außen nach innen und in umgekehrter Richtung. Er erlaubt vor allem eine sehr genaue Einstellung der Wachstumsbedingungen, insbesondere der Druckverhältnisse, in der Innenzone des Tiegels. Damit wird die Herstellung eines qualitativ sehr hochwertigen und großvolumigen AlN-Einkristalls ermöglicht. Über die vorstehend genannte Möglichkeit zur Variation des Drucks lässt sich auch die Wachstumsgeschwindigkeit gezielt einstellen.

Aufgrund der langsamen Zu- oder Abführung von Gaskomponenten durch die Tiegelwand werden weder der Transportstrom der Gasphase vom Vorratsbereich zum Kristallbereich noch der für ein kontrolliertes Aufwachsen des AlN-Einkristalls ganz wesentliche Temperaturgradient gestört, d.h. negativ beeinflusst. Die gasdurchlässige Ausführungsform und der langsame, d.h. der insbesondere ohne laminare oder turbulente Strömung ablaufende, Diffusionsmechanismus gestatten eine sehr kleine, insbesondere infinitesimale Druckänderung in der Innenzone. Dadurch kann die Züchtung des AlN-Einkristalls praktisch zu jedem Zeitpunkt in der Nähe des Gleichgewichts, also unter quasi-stationären Bedingungen, stattfinden.

Auch auf die Stöchiometrie innerhalb der Gasphase und auf diejenige an der Wachstumsoberfläche, also an der Phasengrenzfläche zwischen Gasphase und AlN-Einkristall, wirkt sich die Diffusion positiv aus. Die Stöchiometrie lässt sich zwar gezielt beeinflussen, wodurch ein wesentlicher Vorteil gegenüber den bekannten Verfahren mit versiegeltem Tiegel und damit ohne vergleichbarer Möglichkeit zur Einflussnahme von außen besteht. Dies geschieht jedoch stets unter Einhaltung der quasi-stationären Prozessverhältnisse, d.h. nahe am Gleichgewichtszustand, so dass es dadurch nicht zu einer unerwünscht starken Störung des Gleichgewichtszustands im Bereich der Wachstumsoberfläche kommt. Dagegen ist diese Gefahr bei den bekannten Verfahren mit offenem Tiegel aufgrund der starken Gasströmung vor der Wachstumsoberfläche durchaus gegeben.

Auch die Dotierung des aufwachsenden AlN-Einkristalls lässt sich so in einfacher Weise und gezielt steuern. Neben Al- und N-haltigen Gaskomponenten können nämlich auch Dotierstoffe zur Diffusion in die Innenzone vorgesehen werden. Damit ist es möglich, die Dotierung des aufwachsenden AlN-Einkristalls in weiten Grenzen zu beeinflussen. Sowohl n-leitendes als auch p-leitendes, aber auch semi-isolierendes Verhalten kann so problemlos eingestellt werden.

Die Beeinflussung der Gasphase in der Innenzone mittels der Diffusion kann beispielsweise je nach festgestelltem aktuellen Bedarf während des Züchtungsprozesses variiert werden. Insbesondere kann sie temporär erfolgen. Sollte bei der Überwachung festgestellt werden, dass bestimmte Komponenten in der Gasphase innerhalb der Innenzone fehlen, so können gerade diese Komponenten gezielt nachgeführt werden. Andererseits kann eine derartige Diffusion auch unterbleiben, wenn die Gasphase aktuell die Bedingungen für ein gutes AlN-Einkristallwachstum erfüllt.

Insgesamt ermöglichen das erfindungsgemäße Verfahren und die erfindungsgemäße Vorrichtung also die Züchtung eines AlN-Einkristalls von sehr hoher Qualität bei gleichzeitig großem Volumen. Damit sind die Voraussetzungen geschaffen, elektronische oder optoelektronische Bauelemente auf AlN-Basis in großtechnischem und wirtschaftlichem Maßstab herzustellen.

Vorteilhafte Ausgestaltungen des Verfahrens und der Vorrichtung gemäß der Erfindung ergeben sich aus den von Anspruch 1 bzw. Anspruch 8 abhängigen Ansprüchen.

Die gasdurchlässige Ausführung des Tiegels wird bei einer ersten vorteilhaften Variante dazu verwendet, das Quellmaterial insbesondere vor der eigentlichen AlN-Einkristall-Herstellung zu reinigen. Hierbei diffundieren unerwünschte Verunreinigungen von innen nach außen durch die gasdurchlässige Tiegelwand. Diese vorgeschaltete Reinigung steigert die Qualität des danach aufwachsenden AlN-Einkristalls erheblich.

Günstigerweise enthält der zur Diffusion bestimmte Teilbereich der Tiegelwand ein gasdurchlässiges, insbesondere ein poröses, Tiegelmaterial, das vorzugsweise eine Diffusion, aber keine direkte Strömung gestattet, oder besteht aus diesem.

Vorzugsweise kommt für das gasdurchlässige Tiegelmaterial ein Keramikmaterial, ein Metallschaum oder ein Sintermetall, insbesondere jeweils mit einer relativen Dichte zwischen 50 % und 95 %, zum Einsatz. In diesem Dichte-Bereich ist das Material noch nicht gasdicht, aber auch nur so durchlässig, dass eine langsame Diffusion stattfinden kann.

Günstig ist es außerdem, wenn das gasdurchlässige Tiegelmaterial eine offene Porosität zwischen 0,1 % und 10 % aufweist. Dieser Bereich der offenen Porosität ist besonders ausgezeichnet einerseits durch einen für die gewünschte Prozessbeeinflussung ausreichend hohen Materialtransport durch das gasdurchlässige Tiegelmaterial hindurch sowie andererseits durch einen ausreichend hohen "Diffusionswiderstand", der eine insbesondere im Kristallbereich unerwünschte Gasströmung in der Innenzone des Tiegels zu vermeiden hilft. Der für den Materialtransport durch das gasdurchlässige Tiegelmaterial hindurch verantwortliche Diffusionsmechanismus geht dann sehr langsam vonstatten.

Gerade bei einem bevorzugten Porenkanaldurchmesser zwischen 1 µm und 100 µm verhält sich das gasdurchlässige Tiegelmaterial praktisch wie eine Transportbremse, ohne jedoch den Materialtransport komplett zu unterbinden. Dadurch wird die direkte Einflussnahme auf die Prozessatmosphäre mittels der Diffusion weiter reduziert.

Ein bevorzugt als gasdurchlässiges Tiegelmaterial eingesetztes Keramikmaterial enthält Siliciumcarbid (SiC) oder ein Nitrid, wie beispielsweise Bornitrid (BN), Aluminiumnitrid (AlN) oder Siliciumnitrid (Si₃N₄), oder eine andere Nichtoxid-Keramik. Sauerstoff sollte nämlich nicht als Bestandteil des verwendeten Keramikmaterials vorgesehen werden, um die Gefahr eines unkontrollierten Einbaus von Sauerstoff, der zu-, vor im Zuge der Diffusion aus dem gasdurchlässigen Tiegelmaterial herausgelöst worden ist, als Dotierstoff in den aufwachsenden AlN-Einkristall zu reduzieren.

Es kann aber auch poröses Metall, beispielsweise in Form eines Metallschaums oder eines Sintermetalls, als gasdurchlässiges Tiegelmaterial verwendet werden. Ein solches poröses Metall kann besonders rein hergestellt werden, so dass die Diffusion durch ein solches poröses Metall hindurch keine Verunreinigung in die Innenzone einträgt. Weiterhin ist ein solches poröses Metall inert gegenüber den Komponenten der Gasphase in der Innenzone des Tiegels. Dies gilt insbesondere, wenn das poröse Metall auf Basis eines Refraktärmetalls, wie zum Beispiel Wolfram (W) oder Tantal (Ta) gebildet ist. Sowohl Wolfram (W) als auch Tantal (Ta) sind hochtemperaturstabil und eignen sich deshalb sehr gut für einen Einsatz bei den hohen Prozesstemperaturen während der Züchtung des AlN-Einkristalls. Ein poröses Metall aus einer Legierung eines Refraktärmetalls, insbesondere von Wolfram oder von Tantal, beispielsweise einer Tantalcarbid (TaC)-Legierung ist ebenso möglich.

Vorteile bietet eine weitere Variante, bei dem sich zwischen dem Vorratsbereich und dem Kristallbereich eine gasdurchlässige Diffusionsmembran befindet. Dann erfolgt der Transport der aus dem Quellmaterial gewonnen Komponenten der Gasphase zum Kristallbereich mittels einer Diffusion durch die Diffusionsmembran. Dadurch ergibt sich ein besonders homogener Gastransport zum aufwachsenden AlN-Einkristall. Insbesondere, wenn die von außerhalb in die Innenzone diffundierenden Komponenten der Gasphase zunächst in den Vorratsbereich gelangen, passieren auch diese Komponenten die Diffusionsmembran auf ihrem Weg zum aufwachsenden AlN-Einkristall. Sie erfahren also eine zweimalige Diffusion, wodurch sich die Homogenisierung zusätzlich verbessert und die Gefahr einer negativen Beeinflussung der Züchtungsparameter in der Gasphase weiter reduziert wird. Auch die Diffusionsmembran besteht bevorzugt aus einem der vorstehend genannten vorteilhaften gasdurchlässigen Tiegelmaterialien.

Bevorzugte, jedoch keinesfalls einschränkende Ausführungsbeispiele der Erfindung werden nunmehr anhand der Zeichnung näher erläutert. Zur Verdeutlichung ist die Zeichnung nicht maßstäblich ausgeführt, und gewisse Aspekte sind schematisiert dargestellt. Im Einzelnen zeigen die:
- Figuren 1 bis 3: Vorrichtungen zur Züchtung eines AlN-Einkristalls mittels eines gasdurchlässigen Tiegels und
- Figur 4: eine Vorrichtung zur Züchtung mehrerer AlN-Einkristalle

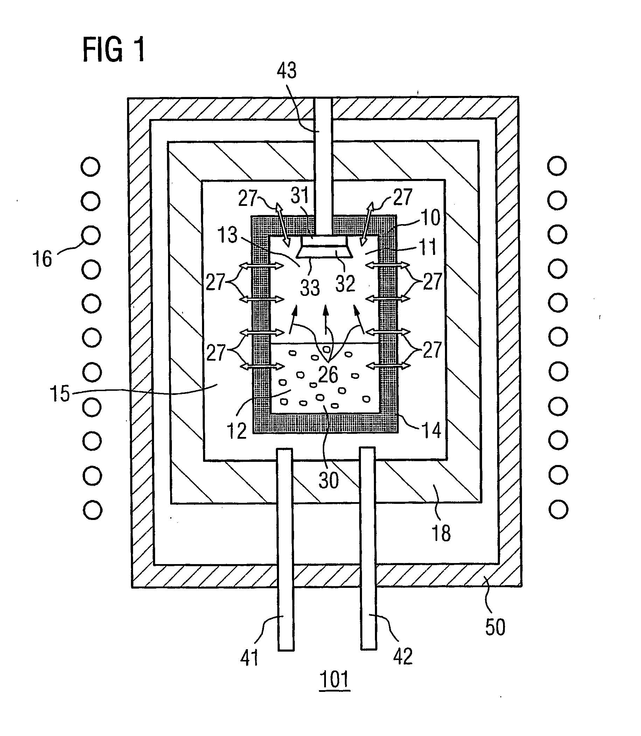

Einander entsprechende Teile sind in den Figuren 1 bis 4 mit denselben Bezugszeichen versehen.

In Figur 1 ist in Schnittdarstellung eine Vorrichtung 101 zur Sublimationszüchtung eines Aluminiumnitrid(AlN)-Einkristalls 32, der insbesondere in Form eines Volumeneinkristalls auf einem Keimkristall 31 aufwächst, gezeigt. Für die Sublimationszüchtung wird ein Tiegel 10 mit einer von einer Tiegelwand 14 umschlossenen Innenzone 11 eingesetzt. Das Kristallwachstum findet in einem Kristallbereich 13 der Innenzone 11 statt. Der Keimkristall 31 ist an der oberen Begrenzungswand des Tiegels 10 angebracht. Am Boden des Tiegels befindet sich in einem Vorratsbereich 12 ein Vorrat aus einem Quellmaterial 30 das bei einer Prozesstemperatur von vorzugsweise über 2000°C sublimiert wird. Dadurch entsteht eine AlN-Gasphase, die als Gasspezies Al- und N-haltige Komponenten enthält. Diese Komponenten der AlN-Gasphase werden durch einen Gasphasentransport 26 vom Vorratsbereich 12 zum Kristallbereich 13 transportiert und kristallisieren dort an einer Kristallisations- oder Wachstumsoberfläche 33 des aufwachsenden AlN-Einkristalls 32 aus. Eine bevorzugte lichte Weite zwischen der oberen Begrenzungsfläche des Quellmaterials 30 und der Wachstumsoberfläche 33 liegt etwa zwischen 5 und 25 mm. Diese Werte sind jedoch nicht einschränkend zu verstehen. Ein Abstand größer als 25 mm ist durchaus ebenfalls möglich.

Der Gasphasentransport 26 stellt sich auch insbesondere aufgrund eines in der Innenzone 11 vorhandenen axialen Temperaturgradienten mit einem Temperaturgefälle vom heißeren Vorratsbereich 12 zum kühleren Kristallbereich 13 ein. Der Temperaturgradient wird bevorzugt auf einen Wert zwischen 10 und 30°C/cm eingestellt. Grundsätzlich sind jedoch auch größere oder kleinere Werte möglich.

Das Quellmaterial 30 im Vorratsbereich 12 kann sowohl aus einem kompakten AlN-Materialblock, insbesondere aus gesintertem AlN-Pulver, oder auch aus vorzugsweise hochreinem pulverförmigem AlN mit einer bevorzugten Korngröße zwischen 10 und 250 µm bestehen. Das AlN kann dabei polykristallin oder auch einkristallin ausgebildet sein. Im Beispiel von Figur 1 ist ein polykristallines AlN-Pulver als Quellmaterial 30 vorgesehen. Darüber hinaus gibt es auch Ausführungsformen, bei denen nur ein Teil der Ausgangssubstanzen in fester Form vorliegt. Insbesondere der für die AlN-Gasphase benötigte Stickstoffanteil wird dabei zumindest teilweise gasförmig zugeführt. Bei einer ersten solchen Ausführungsform besteht das Quellmaterial 30 aus metallischem Aluminium, wohingegen Stickstoff ausschließlich über einen N₂-Gaszufluss in eine Außenzone 15 des Tiegels 10 und anschließende Diffusion durch die Tiegelwand 14 bereitgestellt wird. Bei einer anderen Ausführungsform befindet sich eine Mischung aus festem AlN und Al als Quellmaterial 30 im Vorratsbereich 12 und zusätzlich wird ein NH₃-Gas zugeführt, um eine ausreichende Stickstoff-Versorgung für das AlN-Wachstum sicherzustellen.

Der Tiegel 10 wird mittels einer insbesondere induktiven Heizeinrichtung 16 auf eine Prozesstemperatur von vorzugsweise 2000 bis 2300°C aufgeheizt. Die Prozesstemperatur kann aber auch zwischen 1800 und 2000°C oder zwischen 2300 und 2400°C liegen. Die Heizeinrichtung 16 enthält im Beispiel von Figur 1 eine außerhalb eines Gehäuses 50 angeordnete Heizspule, mittels der in der Tiegelwand 14 ein Induktionsstrom erzeugt wird, der die Tiegelwand 14 und damit den Tiegel 10 insgesamt aufheizt. Grundsätzlich ist auch eine andere Heizeinrichtung, beispielsweise eine resistive Heizeinrichtung oder eine Kombination aus einer induktiven und einer resistiven Teilheizeinrichtung, denkbar. Zwischen der Heizeinrichtung 16 und dem Tiegel 10 ist eine thermische Isolation 18 vorzugsweise aus Graphitschaum angeordnet, um den Tiegel 10 möglichst gut vor einem Wärmeverlust durch Wärmeabstrahlung zu schützen. Eine resistive Heizeinrichtung könnte im Unterschied zu der Darstellung von Figur 1 auch innerhalb des Gehäuses 50 angeordnet sein.

Die Temperatur im Bereich des aufwachsenden AlN-Einkristalls 32 lässt sich mittels eines - nicht dargestellten - Pyrometers überwachen. Hierzu ist in dem zur gasdichten Kapselung vorgesehenen Gehäuse 50, der Isolation 18 und dem Tiegel 10 ein Pyrometerkanal 43 vorgesehen. Die so gewonnenen Informationen über die Temperatur können dann insbesondere zur Steuerung der Heizeinrichtung 16 herangezogen werden.

Als Keimkristall 31 wird vorzugsweise ein AlN-Keimkristall eingesetzt, wobei die Wachstumsoberfläche 33 sowohl der Alals auch der N-Seite, d.h. der kristallographischen Al- bzw. N-Richtung, entsprechen kann. Eine geringfügige Fehlorientierung (= Off-Orientierung) von der kristallographischen Hauptachse um einen Winkelwert zwischen 0° und 6° können das Wachstum des AlN-Einkristalls 32 zusätzlich begünstigen. Weiterhin ist es aber ebenso möglich, als Keimkristall 31 einen Siliciumcarbid(SiC)-Keimkristall, beispielsweise der Polytypen 6H, 4H oder 15R, zu verwenden. Als Wachstumsoberfläche 33 kommt entweder die Si- oder die C-Seite ebenfalls mit einer möglichen Fehlorientierung im Rahmen der vorstehend bereits genannten Winkelwerte in Betracht. Ansonsten ist grundsätzlich eine weitgehend beliebige Orientierung innerhalb des SiC-Kristallgitters möglich. Der SiC-Keimkristall kann auch mittels eines beliebigen Epitaxieverfahrens (zum Beispiel: MOCVD, CVD, VPE, PVD oder anderes) vorab beschichtet worden sein. Die Beschichtung besteht vorzugsweise aus einer (AIN)ₓ/(SiC)y-Legierung mit x ∈ [0; 100] und y = 100 - x.

Der Keimkristall 31 ist mittels einer nicht dargestellten Halterung an der oberen Begrenzungswand des Tiegels 10 befestigt. Als Material kommt für diese Halterung eine dicht gesinterte Keramik, insbesondere aus Bornitrid (BN), in Frage. Andere Keramikmaterialien wie AlN, Si₃N₄ oder SiC sind ebenfalls möglich. Es können jedoch auch Metalle wie Wolfram, Tantal oder Legierungen derselben jeweils in einkristalliner oder polykristalliner Form verwendet werden. Weiterhin kann die Halterung auch aus einem mit Tantal (Ta) oder Tantalcarbid (TaC) beschichteten Graphitmaterial bestehen.

Die Tiegelwand 14 ist aus einem gasdurchlässigen Tiegelmaterial ausgebildet, das eine Diffusion 27 von gasförmigen Komponenten, insbesondere von in der Prozessatmosphäre vorhandenen Komponenten, zwischen der Innenzone 11 und der außerhalb des Tiegels 10 gelegenen Außenzone 15 zulässt. Mittels eines derartigen Diffusionsmechanismus lässt sich die Prozessatmosphäre in der Innenzone 11 und insbesondere im Kristallbereich 13 von außen kontrollieren und auch gezielt steuern, ohne dabei jedoch den Materialtransport zum Kristallbereich 13 und insbesondere den Gleichgewichtszustand an der Wachstumsoberfläche 33 negativ zu beeinflussen. Ein Gasaustausch zwischen Außenzone 15 und Innenzone 11 erfolgt mittels einer Diffusion von Gasmolekülen durch die Poren des gasdurchlässigen Tiegelmaterials der Tiegelwand 14. Es findet aber insbesondere keine unmittelbare Einströmung von Gaskomponenten in die Innenzone 11 statt. Der Austausch geschieht vielmehr über einen sehr langsamen Diffusionsprozess. Dabei kommt es zu einer vorteilhaften, den Massentransport durch die Tiegelwand 14 verringernden Wechselwirkung zwischen dem insbesondere gasdurchlässigen Tiegelmaterial der Tiegelwand 14 und der transportierten Gaskomponente. Dagegen könnte ein Austausch mit der Außenzone 15 über - noch so kleine - Öffnungen in der Tiegelwand 14 auch zu unerwünschten Störungen des Gasphasentransports 26 und insbesondere auch des Gleichgewichtszustand an der Wachstumsoberfläche 33 führen.

Die Tiegelwand 14 besteht aus einem gasdurchlässigen und insbesondere porösen Tiegelmaterial. Vorzugsweise kommen hierfür ein Keramikmaterial oder ein Metallschaum jeweils mit einer relativen Dichte zwischen 50 % und 95 % und einer offenen Porosität zwischen 0,1 % und 10 % in Betracht. Im Beispiel von Figur 1 besteht die Tiegelwand 14 aus einer Bornitrid(BN)-Keramik mit einem Porenkanaldurchmesser zwischen 1 µm und 100 µm. Grundsätzlich ist jedoch auch eine Keramik aus Aluminiumnitrid (AlN), aus Siliciumnitrid (Si₃N₄) oder aus Siliciumcarbid (SiC) oder eine andere Nichtoxid-Keramik geeignet. Eine Oxid-Keramik wäre demgegenüber vor allem deshalb ungünstig, da dann aus dem gasdurchlässigen Tiegelmaterial der Tiegelwand 14 stammender Sauerstoff unkontrolliert in den aufwachsenden AlN-Einkristall als Dotierstoff eingebaut werden könnte. Insbesondere, wenn die Tiegelwand 14 aus einem elektrisch isolierenden Material, wie der vorstehend genannten Bornitrid(BN)-Keramik, besteht und eine induktive Heizeinrichtung 16 vorgesehen ist, kann zusätzlich im Innern des Gehäuses 50 ein in Figur 1 nicht gezeigter, elektrisch leitender Suszeptor vorgesehen sein. Dieser ist dann bevorzugt rohrförmig ausgebildet und umgibt den Tiegel 10. Alternativ könnte jedoch anstelle der induktiven Heizeinrichtung 16 auch eine zwischen dem Tiegel 10 und der Isolation 18 angeordnete resistive Heizeinrichtung vorgesehen sein. Dann ist ein zusätzlicher Suszeptor entbehrlich.

Die Diffusion 27 wird insbesondere durch die Porosität der genannten gasdurchlässigen Tiegelmaterialien gewährleistet. Die offene Porosität und auch die angegebenen bevorzugten Porenkanaldurchmesser stellen sicher, dass zum einen überhaupt ein gewisser Anteil an durchgängigen Porenkanälen für einen Materialtransport durch die Tiegelwand vorhanden ist, und der Materialtransport sich dann aber zum anderen nicht direkt oder unmittelbar, sondern nur sehr langsam und über die im Rahmen einer Diffusion üblichen Umwege vollzieht.

Im Unterschied zum Tiegel 10 ist das Gehäuse 50 gasdicht ausgeführt. Es kann aus Glas, Quarzglas oder einem Metall, wie beispielsweise einer Stahlsorte, bestehen. Im Beispiel von Figur 1 ist es aus Quarzglas hergestellt.

Anhand des beschriebenen Diffusionsmechanismus in der Tiegelwand 14 lässt sich eine Steuerung der Prozessparameter bewirken. So kann insbesondere der Druck in der Innenzone 11, der ein maßgeblicher Parameter für das Kristallwachstum ist, variiert und genau auf den aktuell gewünschten Wert eingestellt werden. Üblicherweise findet das AlN-Wachstum bei einem Druck zwischen 200 und 600 mbar statt. Werte zwischen 1 und 200 mbar sowie zwischen 600 und 1000 mbar eignen sich jedoch ebenfalls zur AlN-Kristallzüchtung.

Der Druck in der Innenzone 11 wird außer durch die Al- und N-haltigen Gasspezies auch durch ein Prozessgas bestimmt. In Frage kommen hierfür Inertgase wie Argon (Ar), Helium (He) oder Xenon (Xe). Gerade im vorliegenden Beispiel mit der Züchtung eines Stickstoff-haltigen Einkristalls ist es günstig, auch ein Stickstoff-haltiges Prozessgas vorzusehen. Ein besonders vorteilhaftes Prozessgas ist deshalb ein N₂-Gas. Ebenso möglich ist aber auch eine Mischung aus Stickstoff und einem Inertgas. Verwenden lässt sich auch ein Gas aus NH₃ oder aus einer N/Cl-Verbindung.

Die Vorrichtung 101 wird vor dem Start des eigentlichen Züchtungsvorganges, vorzugsweise auf ein Hochvakuum, evakuiert. Hierbei werden unerwünschte Verunreinigungen aus der Innenzone 11 mittels Diffusion 27 von innen nach außen entfernt. Nach gegebenenfalls durchgeführten weiteren Reinigungsschritten wird der Züchtungsdruck in der Innenzone 11 mittels von außen nach innen-diffundierendem Inert- oder Prozessgas eingestellt. Während des Züchtungsvorgangs kann aufgrund der gasdurchlässigen Ausbildung der Tiegelwand 14 auch weiteres Inert- oder Prozessgas zugeführt werden. Anhand einer Gaszuführung 41 gelangt das Prozessgas in die Außenzone 15 und von dort mittels des bereits beschriebenen Diffusionsmechanismus in die Innenzone 11.

Die Atmosphäre in der Außenzone 15 und damit auch in der Innenzone 11 lässt sich auch über eine weitere Zuführung 42, die an eine (Vakuum-)Pumpe angeschlossen ist, steuern. Die Gaszuführung 41 und auch die Pumpenzuführung 42 sind durch das gasdichte Gehäuse 50 und auch durch die Isolation 18 geführt. Die Pumpe dient insbesondere zur Erzeugung des unter anderem für die Reinigung benötigten Hochvakuums.

Genau wie für das Prozessgas beschrieben, kann auch ein Dotierstoff zunächst in die Außenzone 15 und dann durch die Tiegelwand 14 in die Innenzone 11 zugeführt werden. Als Dotierstoffe kommen für die AlN-Einkristallzüchtung Schwefel (S), Silizium (Si) und Sauerstoff (O) in Frage. Alle drei genannten Elemente können in AlN als Donator fungieren, wobei Silizium auch eine Akzeptor-Funktion ausüben kann. Andere zwei-, drei-, fünf- oder sechswertige Elemente können ebenfalls grundsätzlich in der beschriebenen Art und Weise als Dotierstoffe in die Innenzone 11 eingebracht werden. Damit lässt sich der AlN-Einkristall 32 in n-leitender, in p-leitender oder auch in semi-isolierender Ausgestaltung herstellen. Die Dotierung des AlN-Einkristalls 32 kann gezielt gesteuert werden.

Die gasdurchlässige Ausführung des Tiegels 10 bietet außer den genannten Vorteilen auch die Möglichkeit zur Reinigung des Quellmaterials 30 noch vor dem eigentlichen Züchtungsprozess. Dazu wird wie bereits beschrieben in der Außenzone 15 und damit auch in der Innenzone 11 ein Hochvakuum erzeugt. Gasförmige Verunreinigungen in der Atmosphäre innerhalb der Innenzone 11 und - zumindest teilweise - auch solche im Quellmaterial 30 diffundieren in die Außenzone 15 und werden von dort abgesaugt. Anschließend erfolgt eine Spülung der Vorrichtung 101 mit Inert- oder Prozessgas. Optional kann eine Temperatur-Behandlung bei bis zu 1000 °C stattfinden, bei der weitere adsorbierte Verunreinigungen aus dem Quellmaterial 30 herausgelöst und mittels Diffusion 27 und Absaugung entfernt werden. Die gasdurchlässige Tiegelwand 14 ermöglicht somit eine sehr vorteilhafte Reinigungsbehandlung, bei der die Vorrichtung 101 insbesondere zwischen der Reinigung und dem eigentlichen Züchtungsvorgang nicht mehr geöffnet und damit der Gefahr einer erneuten Verunreinigung ausgesetzt werden muss. Anhand dieses vorgeschalteten Reinigungsprozesses kann der Gehalt an Verunreinigungen im Quellmaterial 30 und folglich auch im aufwachsenden AlN-Einkristall 32 erheblich reduziert werden.

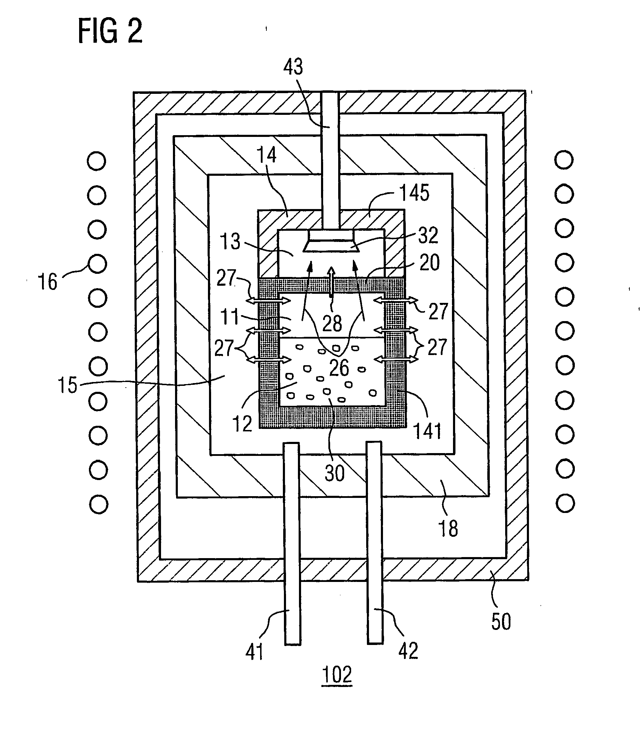

In Figur 2 ist eine weitere Vorrichtung 102 zur Züchtung eines AlN-Einkristalls 32 dargestellt. Im Unterschied zur Vorrichtung 101 von Figur 1 ist der Tiegel 10 nicht komplett, sondern nur im Rahmen eines Teilbehälters 141 gasdurchlässig ausgeführt. Der übrige Teil der Tiegelwand 14 ist in einem Bereich 145 dagegen gasdicht ausgebildet.

Der Teilbehälter 141 besteht aus einem der bereits genannten günstigen gasdurchlässigen Tiegelmaterialien. Im Beispiel von Figur 2 ist eine poröse SiC-Keramik vorgesehen. Der Teilbehälter 141 beinhaltet den Vorratsbereich 12 und dient zur Aufnahme des Quellmaterials 30.

Im Gegensatz dazu besteht der Wandbereich 145 aus einem gasdichten Tiegelmaterial, das beispielsweise als Metall ausgebildet sein kann. Im Beispiel von Figur 2 ist Wolfram (W) als gasdichtes Tiegelmaterial vorgesehen. Alternativ könnte jedoch auch Tantal (Ta) eingesetzt werden. Das Wolfram und auch das Tantal können zusätzlich auch mit einer Wolfram-Legierung bzw. einer Tantal-Legierung (z.B. Tantalcarbid) versehen sein. Grundsätzlich eignen sich auch andere, insbesondere hochschmelzende, d.h. über der Prozesstemperatur schmelzende, Refraktärmetalle für einen Einsatz als gasdichtes Tiegelmaterial. Die Metalle können in ein- oder auch in polykristalliner Form verwendet werden.

Alternativ zu den genannten Metallen kann für das gasdichte Tiegelmaterial aber auch ein Keramikmaterial verwendet werden, vorzugsweise mit einer Dichte von über 90 %, insbesondere von über 95 %. Günstig ist eine heiß und unter hohem Druck gesinterte Bornitrid(BN)-Keramik (= hot isostatic pressed BN) mit einer vernachlässigbaren offenen Porosität, die praktisch bei 0 % liegt. Grundsätzlich ist jedoch auch eine Keramik mit entsprechend hoher Dichte und verschwindender offener Porosität aus einem mittels eines anderen Verfahrens hergestellten, dichten Bornitrid (BN), aus Aluminiumnitrid (AlN), aus Siliciumnitrid (Si₃N₄), aus Siliciumcarbid (SiC) oder aus einem anderen Nichtoxid geeignet. Auch eine mit einer passivierenden Schutzschicht versehenen Aluminiumoxid(Al₂O₃)-Keramik ist als gasdichtes Tiegelmaterial möglich. Die Beschichtung kann dabei aus Beschichtung aus Aluminiumnitrid (AlN), Tantal (Ta) oder Tantalcarbid (TaC) bestehen. Sie dient insbesondere dazu, einen direkten Kontakt des Sauerstoffs des Al₂O₃-Materials mit der Prozessatmosphäre in der Innenzone 11 zu verhindern.

Die durch Sublimation des Quellmaterials 30 erzeugten Komponenten der Gasphase diffundieren durch die obere Begrenzungswand des Teilbehälters 141 und gelangen so zum aufwachsenden AlN-Kristall 32. Die den Vorratsbereich 12 vom Kristallbereich 13 trennende obere Begrenzungswand des Teilbehälters 141 stellt damit eine Diffusionsmembran 20 dar. Der Gasphasentransport 26 vom Vorratsbereich 12 zum Kristallbereich 13 wird ganz wesentlich durch eine Diffusion 28 durch diese Diffusionsmembran 20 mit bestimmt. Insbesondere trägt die Diffusionsmembran 20 zur Unterdrückung von Verwirbelungen und zu einer Homogenisierung des Gasphasentransports 26 bei.

Die Diffusion 27 von der Außenzone 15 in die Innenzone 11 des Tiegels 10 erfolgt überwiegend in einen Bereich des Teilbehälters 141, der zwischen der oberen Begrenzungsfläche des Quellmaterials 30 und der Diffusionsmembran 20 liegt. Die von der Außenzone 15 eindiffundierenden Komponenten gelangen so nur mittels nochmaliger Diffusion 28 in den Kristallbereich 13. Die zweimalige Diffusion fördert die Homogenisierung und reduziert die Gefahr unerwünschter Beeinflussungen aus dem Bereich der Außenzone 15 zusätzlich.

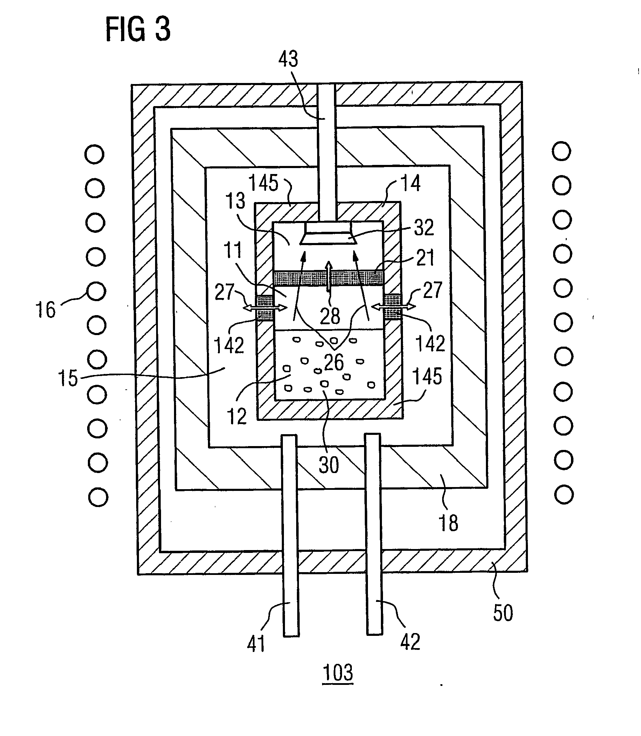

Bei einer weiteren Vorrichtung 103 nach Figur 3 besteht die Tiegelwand 14 im Wesentlichen aus einem der vorstehend bereits aufgeführten bevorzugten gasdichten Tiegelmaterialien, insbesondere aus Wolfram mit einer Tantalcarbid-Beschichtung, und enthält nur einen gasdurchlässigen Einsatz 142 aus einem gasdurchlässigen Tiegelmaterial, im Beispiel von Figur 3 aus einem Tantal-Metallschaum. Durch diesen Einsatz 142 erfolgt die Diffusion 27 von der Außenzone 15 in die Innenzone 11. Außerdem beinhaltet die Vorrichtung 103 eine Diffusionsmembran 21, die zwischen dem Quellmaterial 30 und dem aufwachsenden AlN-Einkristall 32 oberhalb des Einsatzes 142 angeordnet ist und ebenfalls aus einem gasdurchlässigen Tiegelmaterial, im Beispiel von Figur 3 aus einer Aluminiumnitrid(AlN)-Keramik besteht. Das Material der Diffusionsmembran 21 hat eine relative Dichte von zwischen 50 % und 95 %, im Beispiel von Figur 3 von 80 %. Prinzipiell können der Einsatz 142 und die Diffusionsmembran 21 aus verschiedenen gasdurchlässigen Tiegelmaterialien insbesondere auch mit unterschiedlicher relativer Dichte und/oder mit unterschiedlichem Grad an offener Porosität und/oder mit unterschiedlichem Porenkanaldurchmesser ausgebildet sein.

Insgesamt ergeben sich bei der Vorrichtung 103 im Wesentlichen ganz ähnliche Diffusionsverhältnisse wie im vorhergehenden Beispiel nach Figur 2 bereits beschrieben.

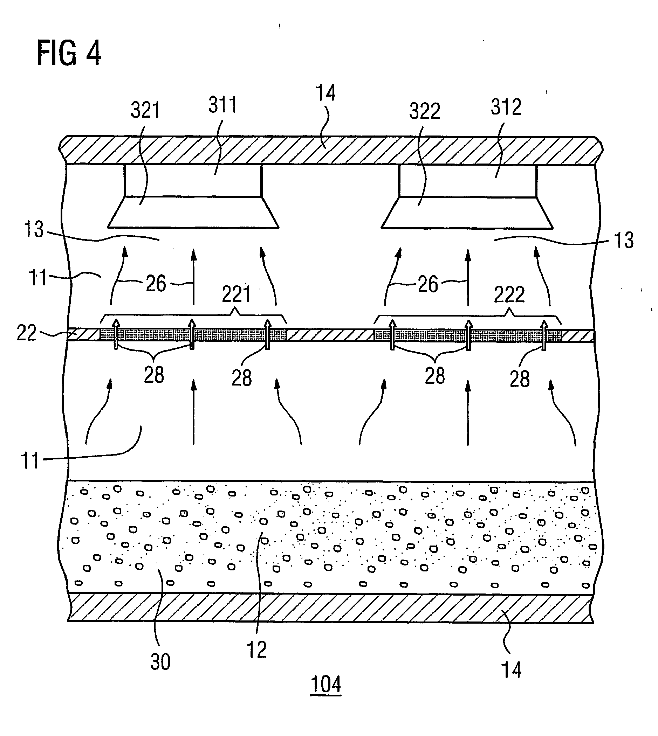

Die in den Figuren 1 bis 3 dargestellten Vorrichtungen 101 bis 103 sind jeweils für die Züchtung eines einzigen AlN-Einkristalls 32 ausgelegt. Ebenso gut gibt es jedoch andere Ausführungsformen, die die gleichzeitige Züchtung mehrerer AlN-Einkristalle zulassen. Eine solche Vorrichtung 104 zur gleichzeitigen Sublimationszüchtung mehrerer AlN-Einkristalle ist beispielhaft in Figur 4 gezeigt. Ohne Einschränkung der Allgemeingültigkeit sind im Beispiel von Figur 4 nur zwei Keimkristalle 311 und 312 mit den darauf aufwachsenden AlN-Einkristallen 321 bzw. 322 gezeigt. Die Vorrichtung 104 von Figur 4 enthält außerdem eine gemeinsame Diffusionsmembran 22 mit mehreren Diffusionsabschnitten 221 und 222. Die Diffusionsabschnitte 221 und 222 sind jeweils einem der AlN-Einkristalle 321 bzw. 322 zugeordnet. Jeder Diffusionsabschnitt 221 und 222 steuert den Gasphasentransport 26 zum jeweils zugeordneten AlN-Einkristall 321 bzw. 322.

Mit den in den Figuren 1 bis 4 gezeigten Vorrichtungen 101 bis 104 lässt sich ein Aluminiumeinkristall 32, 321 und 322 von besonderer Qualität und auch Größe herstellen. Es kann problemlos eine Kristalllänge von 10 bis 30 mm erreicht werden, wobei das Verhältnis zwischen Länge und Durchmesser zwischen 0,25 und 1 liegt. Der erzielte Kristalldurchmesser beträgt insbesondere mehr als 10 mm. Aus dem gezüchteten AlN-Einkristall 32 lassen sich somit Wafer für die Bauelementeherstellung gewinnen, die einen Durchmesser von 2 Zoll oder auch 3 Zoll und mehr aufweisen. Die Wachstumsgeschwindigkeit liegt zwischen 50 und 500 µm/h, kann aber auch auf größere Werte eingestellt werden.

## Patentansprüche

1. Verfahren zur Herstellung mindestens eines AlN-Einkristalls (32), bei dem mindestens
a) eine Gasphase zumindest teilweise aus einem Quellmaterial (30), das sich in einem Vorratsbereich (12) eines Tiegels (10) befindet und zumindest eine Komponente des AlN-Einkristalls enthält, erzeugt wird und
b) der AlN-Einkristall (32) in einem Kristallbereich (13) des Tiegels (10) mittels Wachstum aus der Gasphase erzeugt wird,
**dadurch gekennzeichnet, dass**
c) zumindest eine gasförmige Komponente zumindest zeitweise mittels einer ersten Diffusion (27) zwischen einer Außenzone (15) des Tiegels (10) und einer Innenzone (11) des Tiegels (10) transferiert wird.

2. Verfahren nach Anspruch 1, bei dem zumindest ein Teil der in der Gasphase vorhandenen Komponenten mittels der ersten Diffusion (27) von außerhalb des Tiegels (10) in die Innenzone (11) eingebracht wird.

3. Verfahren nach Anspruch 1 oder 2, bei dem das Quellmaterial (30) gereinigt wird, indem zumindest eine Verunreinigungskomponente mittels der ersten Diffusion (27) aus der Innenzone (11) in die Außenzone (15) gebracht wird.

4. Verfahren nach einem der Ansprüche 1 bis 3, bei dem ein Tiegel (10) verwendet wird, bei dem die erste Diffusion (27) im gesamten Bereich einer Tiegelwand (14) stattfinden kann.

5. Verfahren nach einem der Ansprüche 1 bis 3, bei dem ein Tiegel (10) verwendet wird, bei dem die erste Diffusion (27) in einem gasdurchlässigen Teilbereich (141, 142) einer Tiegelwand (14) stattfinden kann.

6. Verfahren nach einem der Ansprüche 1 bis 3, bei dem zwischen dem Vorratsbereich (12) und dem Kristallbereich (13) eine gasdurchlässige Diffusionsmembran (20, 21) angeordnet wird, um die Gasströmung zu vergleichmäßigen.

7. Verfahren nach Anspruch 6, bei dem zumindest ein Teil der mittels der ersten Diffusion (27) in die Innenzone (11) gelangten Komponenten der Gasphase mittels einer zweiten Diffusion (28) durch die gasdurchlässige Diffusionsmembran (20, 21) in den Kristallbereich (13) transportiert wird.

8. Vorrichtung zur Herstellung mindestens eines AlN-Einkristalls (32) umfassend mindestens einen Tiegel (10),
a) dessen Tiegelwand (14) eine mindestens einen Vorratsbereich (12) und mindestens einen Kristallbereich (13) aufweisende Innenzone (11) des Tiegels (10) von einer Außenzone (15) des Tiegels (10) trennt, wobei der Vorratsbereich (12) der Innenzone (11) der Aufnahme eines zumindest eine Komponente des AlN-Einkristalls (32) enthaltenden Quellmaterials (30) dient und innerhalb des Kristallbereichs (13) der Innenzone (11) das Wachstum des AlN-Einkristalls (32) aus einer Gasphase stattfindet
b) und dessen Tiegelwand (14) zumindest in einem Teilbereich (14, 141, 142) aus einem Tiegelmaterial besteht oder zumindest ein solches Tiegelmaterial enthält, welches die Diffusion einer gasförmigen Komponente zwischen der Außenzone (15) des Tiegels (10) und der Innenzone (11) des Tiegels (10) zulässt, und worin
dieses Tiegelmaterial eine im Bereich zwischen 50% und 95% liegende relative Dichte aufweist.

9. Vorrichtung nach Anspruch 8, bei der das Tiegelmaterial eine im Bereich zwischen 0,1 % und 10 % liegende offene Porosität aufweist.

10. Vorrichtung nach Anspruch 8 oder 9, bei der das Tiegelmaterial einen im Bereich zwischen 1 µm und 100 µm liegenden Porenkanaldurchmesser aufweist.

11. Vorrichtung nach einem der Ansprüche 8 bis 10, bei der das Tiegelmaterial ein Keramikmaterial ist.

12. Vorrichtung nach Anspruch 11, bei der das Keramikmaterial aus Siliciumcarbid, aus einem Nitrid, oder aus einer anderen Nichtoxid-Keramik besteht.

13. Vorrichtung nach Anspruch 12, **dadurch gekennzeichnet, dass** das Keramikmaterial aus Bornitrid, Aluminiumnitrid oder Siliciumnitrid besteht.

14. Vorrichtung nach einem der Ansprüche 8 bis 10, bei der das Tiegelmaterial ein poröses Metall, ein Metallschaum oder ein Sintermetall ist.

15. Vorrichtung nach Anspruch 14, bei der der poröse Metallschaum mit einem Refraktärmetall oder einer Legierung eines Refraktärmetalls gebildet ist.

16. Vorrichtung nach Anspruch 14 oder 15, bei der das poröse Metall mit Wolfram oder Tantal oder einer Legierung von Wolfram oder Tantal gebildet ist.

17. Vorrichtung nach einem der Ansprüche 8 bis 16, bei der die komplette Tiegelwand (14) gasdurchlässig ausgebildet ist.

18. Vorrichtung nach einem der Ansprüche 8 bis 16, bei der als gasdurchlässiger Teilbereich ein abgeschlossener, gasdurchlässiger Teilbehälter (141), der auch zur Aufnahme des Vorratsbereichs (12) bestimmt ist, vorgesehen ist.

19. Vorrichtung nach einem der Ansprüche 8 bis 16, bei der als gasdurchlässiger Teilbereich ein gasdurchlässiger Einsatz (142) in der Tiegelwand (14) vorgesehen ist.

20. Vorrichtung nach einem der Ansprüche 8 bis 19, bei der zwischen dem Vorratsbereich (12) und dem Kristallbereich (13) eine gasdurchlässige Diffusionsmembran (20, 21) angeordnet ist.

21. Vorrichtung nach Anspruch 20, bei der die Diffusionsmembran (21) aus einem Keramikmaterial, einem porösen Metall, einem Metallschaum oder einem Sintermetall besteht oder zumindest ein solches Material enthält.

## Claims

1. Method for producing at least one AlN single crystal (32), wherein at least
a) one gas phase is generated at least partially from a source material (30) which is located in a holding area (12) of a crucible (10) and contains at least one component of the AlN single crystal, and
b) the AlN single crystal (32) is generated in a crystallising area (13) of the crucible (10) by means of growth from the gas phase,
**characterised in that**
c) at least one gaseous component is transferred at least temporarily by means of a first diffusion (27) between an outer zone (15) of the crucible (10) and an inner zone (11) of the crucible (10).

2. Method according to claim 1, wherein at least some of the components present in the gas phase are introduced by means of the first diffusion (27) from outside the crucible (10) into the inner zone (11).

3. Method according to claim 1 or 2, wherein the source material (30) is cleaned in that at least one contamination component is moved by means of the first diffusion (27) from the inner zone (11) into the outer zone (15).

4. Method according to one of claims 1 to 3, wherein a crucible (10) is used in which the first diffusion (27) can take place over the entire area of a crucible wall (14).

5. Method according to one of claims 1 to 3, wherein a crucible (10) is used in which the first diffusion (27) can take place in a gas-permeable subarea (141,142) of a crucible wall (14).

6. Method according to one of claims 1 to 3, wherein a gas-permeable diffusion membrane (20, 21) is arranged between the holding area (12) and the crystallising area (13) in order to homogenise the gas flow.

7. Method according to claim 6, wherein at least some of the components of the gas phase that reached the inner zone (11) by means of the first diffusion (27) are transported through the gas-permeable diffusion membrane (20, 21) into the crystallising area (13) by means of a second diffusion (28).

8. Apparatus for producing at least one AlN single crystal (32), comprising at least one crucible (10)
a) whose crucible wall (14) separates an inner zone (11) of the crucible (10) having at least one holding area (12) and at least one crystallising area (13) from an outer zone (15) of the crucible (10), wherein the holding area (12) of the inner zone (11) serves for accommodating a source material (30) containing at least one component of the AlN single crystal (32) and the growth of the AlN single crystal (32) from a gas phase takes place inside the crystallising area (13) of the inner zone (11),
b) and whose crucible wall (14) consists, at least in a subarea (14, 141, 142), of a crucible material or at least contains such a crucible material which permits the diffusion of a gaseous component between the outer zone (15) of the crucible (10) and the inner zone (11) of the crucible (10), and wherein said crucible material has a relative density lying in the range between 50% and 95%.

9. Apparatus according to claim 8, wherein the crucible material has an open porosity lying in the range between 0.1 % and 10 %.

10. Apparatus according to claim 8 or 9, wherein the crucible material has a pore channel diameter lying in the range between 1 µm and 100 µm.

11. Apparatus according to one of claims 8 to 10, wherein the crucible material is a ceramic material.

12. Apparatus according to claim 11, wherein the ceramic material consists of silicon carbide, of a nitride or of some other non-oxide ceramic.

13. Apparatus according to claim 12, **characterised in that** the ceramic material consists of boron nitride, aluminium nitride or silicon nitride.

14. Apparatus according to one of claims 8 to 10, wherein the crucible material is a porous metal, a metallic foam or a sinter metal.

15. Apparatus according to claim 14, wherein the porous metallic foam is formed with a refractory metal or an alloy of a refractory metal.

16. Apparatus according to claim 14 or 15, wherein the porous metal is formed with tungsten or tantalum or an alloy of tungsten or tantalum.

17. Apparatus according to one of claims 8 to 16, wherein the entire crucible wall (14) is embodied as gas-permeable.

18. Apparatus according to one of claims 8 to 16, wherein a self-contained, gas-permeable sub-container (141), which is also intended to accommodate the holding area (12), is provided as a gas-permeable subarea.

19. Apparatus according to one of claims 8 to 16, wherein a gas-permeable insert (142) is provided in the crucible wall (14) as a gas-permeable subarea.

20. Apparatus according to one of claims 8 to 19, wherein a gas-permeable diffusion membrane (20, 21) is arranged between the holding area (12) and the crystallising area (13).

21. Apparatus according to claim 20, wherein the diffusion membrane (21) consists of a ceramic material, a porous metal, a metallic foam or a sinter metal or contains at least one such material.

## Revendications

1. Procédé de fabrication d'au moins un monocristal AlN (32), dans lequel au moins
a) une phase gazeuse est générée au moins en partie à partir d'une matière source (30) qui se trouve dans une zone de réserve (12) d'un creuset (10) et qui contient au moins un composant du monocristal AIN, et
b) le monocristal AlN (32) est généré dans une zone de cristal (13) du creuset (10) par croissance à partir de la phase gazeuse,
**caractérisé en ce qu'**
c) au moins un composant gazeux est transféré au moins temporairement entre une zone extérieure (15) du creuset (10) et une zone intérieure (11) du creuset (10) au moyen d'une première diffusion (27).

2. Procédé selon la revendication 1, dans lequel au moins une partie des composants présents pendant la phase gazeuse sont mis dans la zone intérieure (11) depuis l'extérieur du creuset (10) au moyen de la première diffusion (27).

3. Procédé selon la revendication 1 ou 2, dans lequel la matière source (30) est nettoyée, du fait qu'au moins un composant contaminant est mis de la zone intérieure (11) dans la zone extérieure (15) au moyen de la première diffusion (27).

4. Procédé selon l'une quelconque des revendications 1 à 3, dans lequel un creuset (10) est utilisé, dans lequel la première diffusion (27) peut avoir lieu dans toute la zone d'une paroi de creuset (14).

5. Procédé selon l'une quelconque des revendications 1 à 3, dans lequel un creuset (10) est utilisé, dans lequel la première diffusion (27) peut avoir lieu dans une zone partielle (141, 142), perméable au gaz, d'une paroi de creuset (14).

6. Procédé selon l'une quelconque des revendications 1 à 3, dans lequel une membrane de diffusion (20, 21), perméable au gaz, est disposée entre la zone de réserve (12) et la zone de cristal (13) afin d'homogénéiser le flux gazeux.

7. Procédé selon la revendication 6, dans lequel au moins une partie des composants de la phase gazeuse, arrivés dans la zone intérieure (11) au moyen de la première diffusion (27), est transportée dans la zone de cristal (13) à travers la membrane de diffusion (20, 21), perméable au gaz, au moyen d'une seconde diffusion (28).

8. Dispositif destiné à la fabrication d'au moins un monocristal AlN (32), comprenant au moins un creuset (10),
a) dont la paroi de creuset (14) sépare une zone intérieure (11) du creuset (10), présentant au moins une zone de réserve (12) et au moins une zone de cristal (13), d'une zone extérieure (15) du creuset (10), la zone de réserve (12) de la zone intérieure (11) servant au logement d'une matière source (30) contenant au moins un composant du monocristal AlN (32), et la croissance du monocristal AlN (32) ayant lieu à l'intérieur de la zone de cristal (13) de la zone intérieure (11), à partir d'une phase gazeuse,
b) et dont la paroi de creuset (14) est constituée, au moins dans une zone partielle (14, 141, 142), d'une matière pour creuset ou contient au moins une telle matière pour creuset, laquelle permet la diffusion d'un composant gazeux entre la zone extérieure (15) du creuset (10) et la zone intérieure (11) du creuset (10), et dans lequel
cette matière pour creuset présente une densité relative située dans la plage comprise entre 50% et 95%.

9. Dispositif selon la revendication 8, dans lequel la matière pour creuset présente une porosité ouverte située dans la plage comprise entre 0,1% et 10%.

10. Dispositif selon la revendication 8 ou 9, dans lequel la matière pour creuset présente un diamètre de canal de pores situé dans la plage comprise entre 1 µm et 100 µm.

11. Dispositif selon l'une quelconque des revendication 8 à 10, dans lequel la matière pour creuset est une matière céramique.

12. Dispositif selon la revendication 11, dans lequel la matière céramique est constituée de carbure de silicium, d'un nitrure, ou d'une autre céramique non oxyde.

13. Dispositif selon la revendication 12, **caractérisé en ce que** la matière céramique est constituée de nitrure de bore, de nitrure d'aluminium ou de nitrite de silicium.

14. Dispositif selon l'une quelconque des revendications 8 à 10, dans lequel la matière pour creuset est un métal poreux, une mousse métallique ou un métal fritté.

15. Dispositif selon la revendication 14, dans lequel la mousse métallique poreuse est formée par un métal réfractaire ou un alliage d'un métal réfractaire.

16. Dispositif selon la revendication 14 ou 15, dans lequel le métal poreux est formé par du tungstène ou du tantale ou par un alliage de tungstène ou de tantale.

17. Dispositif selon l'une quelconque des revendications 8 à 16, dans lequel la paroi de creuset complète (14) est réalisée de manière perméable au gaz.

18. Dispositif selon l'une quelconque des revendications 8 à 16, dans lequel un réservoir partiel (141) fermé, perméable au gaz, qui est également destiné au logement de la zone de réserve (12), est ménagé en tant que zone partielle perméable au gaz.

19. Dispositif selon l'une quelconque des revendications 8 à 16, dans lequel un insert (142) perméable au gaz est ménagé dans la paroi de creuset (14) en tant que zone partielle perméable au gaz.

20. Dispositif selon l'une quelconque des revendications 8 à 19, dans lequel une membrane de diffusion (20, 21) perméable au gaz est disposée entre la zone de réserve (12) et la zone de cristal (13).

21. Dispositif selon la revendication 20, dans lequel la membrane de diffusion (21) est constituée d'une matière céramique, d'un métal poreux, d'une mousse métallique ou d'un métal fritté ou contient au moins une telle matière.
